# EUROPEAN PATENT APPLICATION

(11) **EP 4 568 427 A1**
(43) Date of publication of application: **11.06.2025**
(21) Application number: 23858616.8
(22) Date of filing: 22.03.2023
(51) Int. Cl.: H05K 1/02, H05K 3/46

(54) **PRINTED CIRCUIT BOARD HAVING PAD AND COMMUNICATION DEVICE**

(30) Priority: 29.08.2022 CN 202211042562
(71) Applicant: ZTE CORPORATION, Shenzhen, Guangdong 518057 (CN)
(72) Inventor: HUANG, Jianwei, Shenzhen, Guangdong 518057 (CN); WEI, Zhongmin, Shenzhen, Guangdong 518057 (CN)
(74) Representative: Cristinelli, Luca
(86) International application number: PCT/CN2023/083177
(87) International publication number: WO 2024/045574

(57) **Abstract**

The present invention relates to a printed circuit board having a pad, and a communication device. The printed circuit board comprises: a signal layer and a reference layer, wherein the signal layer is provided with a pad, the pad comprises a stub, the reference layer is provided with a first anti-pad, the vertical projection of the stub in the reference layer is located in a coverage area of the first anti-pad, and the first anti-pad is used for reducing the impedance of the stub.

## Description

### Cross-Reference to Related Application

The present invention claims priority to Chinese Patent Application no. CN202211042562.3, filed to the China National Intellectual Property Administration on 29 August 2022 and entitled "Printed Circuit board Having Pad and Communication Device", which is incorporated herein by reference in its entirety.

### Technical Field

The present invention relates to the field of design of printed circuit boards, and in particular, to a printed circuit board having a pad and a communication device.

### Background

With the increase of the signal rate, the performance requirements for signal integrity (SI) of high-speed channels also increase. Signal reflection caused by impedance discontinuity has a great impact on high-speed signals. Therefore, it is important to optimize the impedance of the high-speed channel.

When designing pads on a Printed Circuit Board (PCB), because reliability of soldering needs to be considered, the pads are often designed to be long. However, this can easily lead to low impedance points. A long pad easily forms a stub, and the stub is coupled to a reference ground, which forms a capacitive impedance discontinuity, so that the transmission quality of a high-speed signal is poor. Therefore, how to reduce capacitive coupling between the pad stub and the reference ground becomes a technical problem to be solved urgently.

### Summary

The present invention provides a printed circuit board having a pad and a communication device, so as to solve the technical problem of how to reduce capacitive coupling between a pad stub and a reference ground.

According to a first aspect, the present invention provides a printed circuit board having a pad. The printed circuit board comprises: a signal layer and a reference layer, wherein the signal layer is provided with a pad, the pad comprises a stub, the reference layer is provided with a first anti-pad, the vertical projection of the stub in the reference layer is located in a coverage area of the first anti-pad, and the first anti-pad is configured to reduce the impedance of the stub.

According to a second aspect, the present invention provides a communication device. The communication device comprises the printed circuit board according to the first aspect.

### Brief Description of the Drawings

Accompanying drawings herein are incorporated into the specification and constitute into a part of the specification, show examples consistent with the present invention, and are used to explain principles of the present invention with the specification.

To describe the technical solutions in the embodiments of the present invention or in the existing technology more clearly, the following briefly describes the accompanying drawings required for describing the embodiments or the existing technology. Apparently, a person of ordinary skill in the art may still derive other accompanying drawings from these accompanying drawings without creative efforts.
Fig. 1 is a top-view overlay schematic diagram of a printed circuit board with a surface-mount device pad in some cases;
Fig. 2 is a side view of a printed circuit board with a surface-mount device pad in some cases;
Fig. 3 is a side view of a printed circuit board with a gold finger pad in some cases;
Fig. 4 is an equivalent circuit diagram of a pad fan-out structure of a printed circuit board with a pad in some cases;
Fig. 5 is a side view I of a printed circuit board with a pad according to the present invention;
Fig. 6 is a side view II of a printed circuit board with a pad according to an embodiment of the present invention;
Fig. 7 is a top-view overlay schematic diagram of a printed circuit board with a pad according to an embodiment of the present invention;
Fig. 8 is a schematic diagram of an effect of adding different lengths of stub anti-pad on the channel impedance according to the present invention;
Fig. 9 is a schematic diagram of an effect of signal insertion loss before and after adding a stub anti-pad according to the present invention;
Fig. 10 is a schematic diagram of an effect of signal return loss before and after adding a stub anti-pad according to the present invention;
Fig. 11 is a schematic diagram of a fan-out structure of a first sub-reference layer according to the present invention;
Fig. 12 is a schematic diagram I of a fan-out structure of a second sub-reference layer according to the present invention;
Fig. 13 is a schematic diagram II of a fan-out structure of a second sub-reference layer according to the present invention;
Fig. 14 is a schematic diagram III of a fan-out structure of a second sub-reference layer according to the present invention.

### Detailed Description of the Embodiments

To make the objects, technical solutions, and advantages of the embodiments of the present invention clearer, hereinafter, the technical solutions in the embodiments of the present invention will be described clearly and thoroughly with reference to the accompanying drawings of the embodiments of the present invention. Obviously, the embodiments as described are some of the embodiments of the present invention, and are not all of the embodiments of the present invention. On the basis of the embodiments in the present invention, all other embodiments obtained by a person of ordinary skill in the art without inventive effort shall all belong to the scope of protection of the present invention.

With the increase of the signal rate, the performance requirements for signal integrity (SI) of high-speed channels also increase. Signal reflection caused by impedance discontinuity has a great impact on high-speed signals; excessive signal reflection will affect the transmission quality of high-speed signals, causing signal overshoot/undershoot, ringing, returnloss etc. Therefore, it is important to optimize the impedance of the high-speed channel.

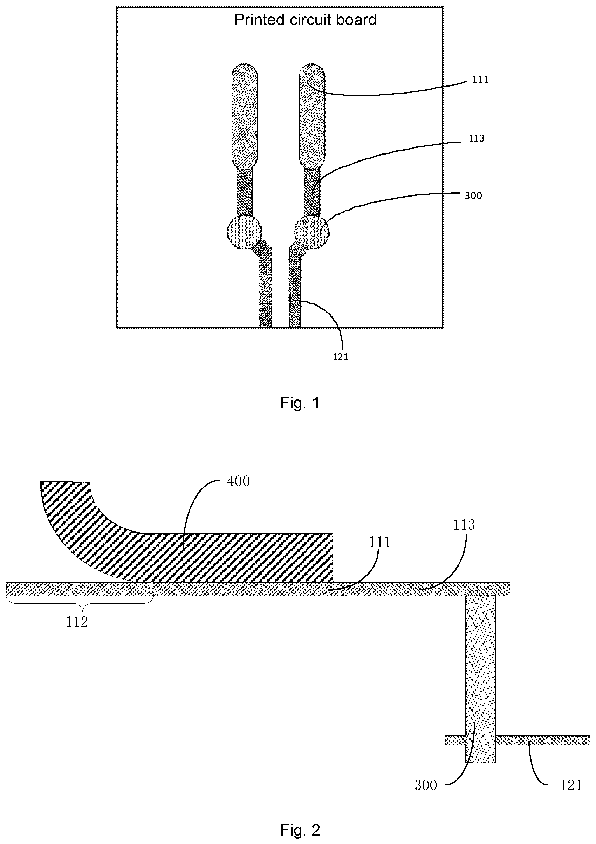

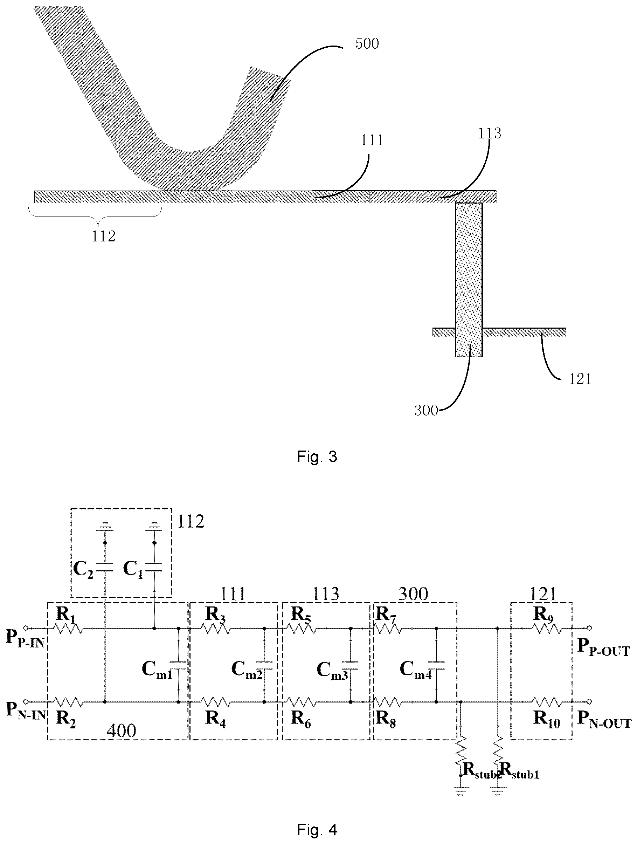

When designing pads, such as surface-mounted Devices (SMD) pads or gold fingers, on a Printed Circuit Board (PCB), because reliability of soldering needs to be considered, the pads are often designed to be long. However, this can easily lead to low impedance points. As shown in Fig. 1, at present, a high-speed differential surface-mount device pad (111) needs to be connected to a differential through hole (300) by means of a differential microstrip line (113) on the surface layer, and the inner layer is fanned out by means of a differential strip line (121). The signal flow direction of the design is: high-speed differential surface-mount device pad (111) → differential microstrip line (113) → differential through hole (300) → differential strip line (121). For the consideration of welding reliability, the high-speed differential surface-mount device pad (111) needs to be longer than the tail end of the L-shaped welding pin (400) in the length direction. As shown in Fig. 2, a branch structure of this portion forms a stub (112), which affects the impedance of the high-speed differential surface-mount device pad (111). Similar to the surface-mounted device pad, in order to ensure the reliability of contact of the gold finger, a section of stub (112) is also left between the contact point of the gold finger pad (111) and the spring sheet (500) and the tail end of the pad, thereby affecting the impedance of the gold finger, as shown in Fig. 3. Accordingly, the stub at the tail end of the surface-mounted device pad or the gold finger pad is coupled to the reference ground to form a capacitive impedance discontinuity, the equivalent circuit thereof is shown in Fig. 4, wherein C1 and C2 are equivalent capacitors of the pad stub; and the equivalent parts of structures such as welding pins and routing lines are as shown by labels. Due to the influence of C1 and C2, the differential signals (PP-IN and PN-IN) connected from the high-speed differential pad (111) are easily reflected, resulting in poor transmission quality of the high-speed signals. Therefore, how to reduce the capacitive coupling between the pad stub and the reference ground, i.e., the values of C1 and C2, to improve the transmission quality of high-speed signals, has become an urgent technical problem to be solved.

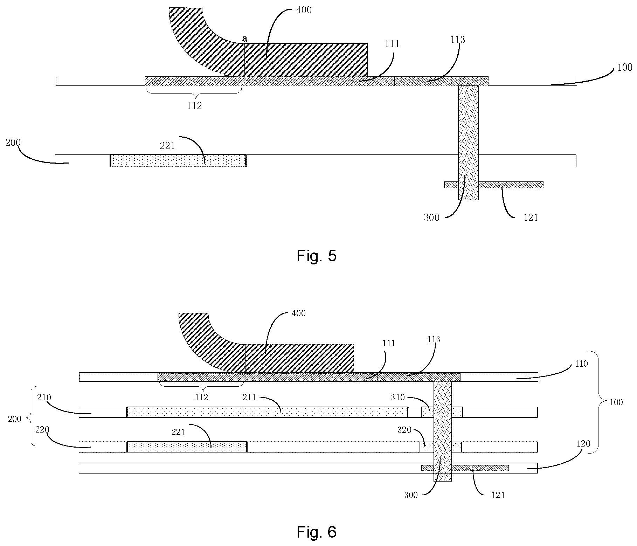

Referring to Fig. 5, Fig. 5 is a side view I of a printed circuit board with a pad according to the present invention. As shown in Fig. 5, printed circuit board comprises: a signal layer 100 and a reference layer 200, wherein the signal layer 100 is provided with a pad 111, the pad 111 comprises a stub 112, the reference layer 200 is provided with a first anti-pad 221, the vertical projection of the stub 112 on the reference layer 200 is located in a coverage area of the first anti-pad 221, and the first anti-pad 221 is configured to reduce the impedance of the stub 112.

In an exemplary embodiment, the pad 111 may be a surface-mounted device pad, may also be a gold finger pad, and may also be other types of pads similar to the surface-mounted device pad or the gold finger pad, which is not specifically limited in the present invention. Whether the pad 111 is a surface-mounted device pad or a gold finger pad, the pad has a stub 112, and the principle is shown in Figs. 2 and 3. For the sake of illustration, all subsequent embodiments use surface-mount device pads for schematic explanation.

The signal layer 100 is configured to access and transmit a high-speed signal, and the reference layer 200 is configured to set a first anti-pad 221, so as to increase the distance between the stub 112 and the reference ground, reduce capacitive coupling and optimize impedance, and improve the signal transmission quality. In an exemplary embodiment, the portion of the pad 111 exceeding the welding end a of the L-shaped welding pin 400 in a length direction (i.e. a direction parallel to the information transmission direction) forms the stub 112. The signal layer 100 may be provided with N pads 111, N being any integer greater than or equal to 1, and each pad 111 may be formed by two sub-pads and is configured to access a high-speed differential signal. The portion of each pad 111 exceeding the welding end a of the L-shaped welding pin 400 in the length direction forms a corresponding stub 112. The reference layer 200 may be provided with N first anti-pads 221, and the N first anti-pads 221 are in one-to-one correspondence with the N first pads 111, that is, the first anti-pad 221 is provided below the area of the stub 112 of each pad 111, so as to reduce impedance of the area of the stub 112 of each pad 111, thereby improving transmission quality of each high-speed signal.

In an exemplary embodiment, as shown in Fig. 6, the signal layer 100 comprises a first sub-signal layer 110 and a second sub-signal layer 120; the reference layer 200 comprises a first sub-reference layer 210 and a second sub-reference layer 220; the first sub-signal layer 110, the first sub-reference layer 210, the second sub-reference layer 220 and the second sub-signal layer 120 are sequentially stacked; the first sub-signal layer 110, the first sub-reference layer 210, the second sub-reference layer 220 and the second sub-signal layer 120 are all provided with a through hole 300 penetrating each other; the first sub-signal layer 110 is provided with a pad 111 and a first signal wiring 113, and the pad 111 is connected to the first signal wiring 113; the second sub-signal layer 120 is provided with a second signal wiring 121, the first signal wiring 113 is connected to the second signal wiring 121 by means of a through hole 300, and the second signal wiring 121 is configured to fan out signals; the first sub-reference layer 210 is provided with a second anti-pad 211, the second sub-reference layer 220 is provided with a first anti-pad 221, the second anti-pad 211 is used for reducing impedance of the pad 111, and the vertical projection of the second anti-pad 211 on the second sub-reference layer 220 comprises a coverage area of the first anti-pad 221.

In an exemplary embodiment, the signal layer 100 may include a first sub-signal layer 110 and a second sub-signal layer 120, and is configured to receive and transmit a signal; and the flow direction of the signal is: pad 111→first signal wiring 113-via 300-second signal wiring 121. The reference layer 200 may comprise a first sub-reference layer 210 and a second sub-reference layer 220, and thus the overall impedance of the pad 111 can be reduced by using the second anti-pad 211 on the first sub-reference layer 210, and the impedance of the stub 112 can be reduced by using the first anti-pad 221 on the second sub-signal layer 120, thereby further improving the transmission quality of a signal.

It should be noted that, the arrangement manner of the first anti-pad 221 and the second anti-pad 211 is removing a metal material in a partial area of the reference layer made of the metal material, and replacing the metal material in the area with an insulating dielectric material. In order to ensure that after the second anti-pad 211 on the first sub-reference layer 210 is used to reduce the impedance of the pad 111, the first anti-pad 221 on the second sub-signal layer 120 can be used to reduce the impedance of the stub 112, the vertical projection of the second anti-pad 211 on the second sub-reference layer 220 needs to include a coverage area of the first anti-pad 221, that is, the size of the second anti-pad 211 is greater than the size of the first anti-pad 221. In this way, it can be ensured that the stub 112 and the first anti-pads 221 are not partially blocked by the metal material of the first sub-reference layer 210, thereby ensuring an impedance optimization effect of the first anti-pad 221 on the stub 112.

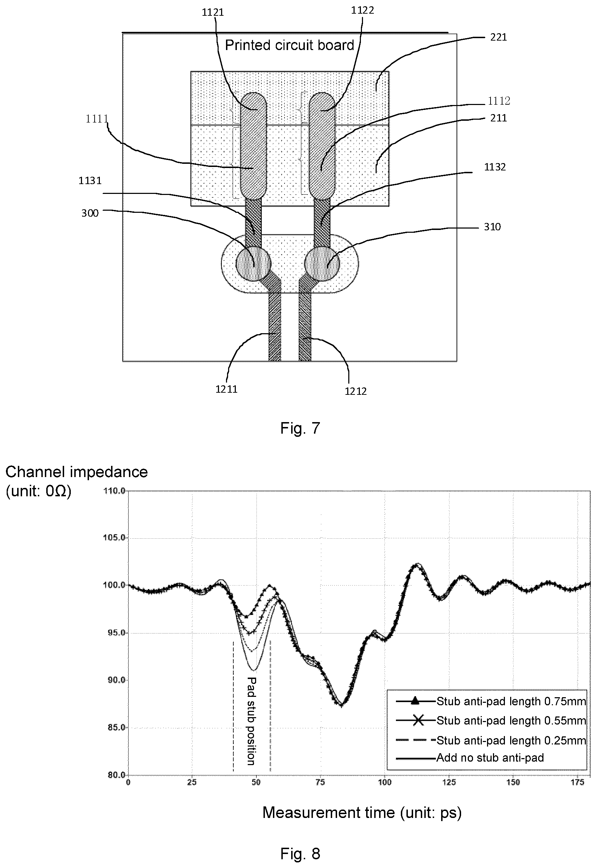

In an exemplary embodiment, referring to Fig. 7, Fig. 7 is a top-view overlay schematic diagram of a printed circuit board with a pad according to an embodiment of the present invention. As shown in Fig. 7, the pad 111 includes a first sub-pad 1111 and a second sub-pad 1112; the first signal wiring 113 includes a first microstrip line 1131 and a second microstrip line 1132; the second signal wiring 121 includes a first strip line 1211 and a second strip line 1212; the first sub-pad 1111 is connected to the first microstrip line 1131; the first microstrip line 1131 is connected to the first strip line 1211 by means of a through hole 300; the first sub-pad 1111 comprises a first stub 1121; the second sub-pad 1112 is connected to the second microstrip line 1132; the second microstrip line 1132 is connected to the second strip line 1212 by means of a through hole 300; and the second sub-pad 1112 includes a second stub 1122.

In an exemplary embodiment, the number of first anti-pads 221 is in one-to-one correspondence with the number of pads 111; and the first anti-pads 221 are used to optimize the impedance of the first stub 1121 on the first sub-pad 1111 among the pads 111 and the impedance of the second stub 1122 on the second sub-pad 1112 among the pads 111. In this way, when a high-speed differential signal is accessed from the first sub-pad 1111 and the second sub-pad 1112, the channel impedance of the high-speed differential signal may be optimized, and the influence of signal reflection on the high-speed differential signal may be reduced, thereby improving the integrity of the high-speed differential signal.

In an exemplary embodiment, referring again to Fig. 7, both the vertical projection of the first sub-pad 1111 on the first sub-reference layer 210 and the vertical projection of the second sub-pad 1112 on the first sub-reference layer 210 are within the coverage area of the second counter-pad 211; the vertical projection of the first stub 1121 on the second sub-reference layer 220 and the vertical projection of the second stub 1122 on the second sub-reference layer 220 are both located within the coverage area of the first anti-pad 221.

In an exemplary embodiment, the second anti-pad 211 is added below the first sub-pad 1111 and the second sub-pad 1112 as the first reference layer 200 of the pad 111, and the size of the second anti-pad 211 may be determined by means of emulation. The second anti-pad 211 is added below the first sub-pad 1111 and the second sub-pad 1112, and an effect of reducing impedance of the first sub-pad 1111 and the second sub-pad 1112 can be achieved by reducing the capacitive coupling between the first sub-pad 1111 and second sub-pad 1112 and the reference ground. The first anti-pad 221 is added below the second anti-pad 211 as the second reference layer 200 of the pad 111. The size of the first anti-pad 221 may be determined by means of emulation. A first anti-pad 221 is added below the first stub 1121 and the second stub 1122, and an effect of reducing the impedances of the first stub 1121 and the second stub 1122 can be achieved by reducing the capacitive coupling between the first stub 1121 and second stub 1122 and the reference ground, thereby avoiding the occurrence of impedance low points, reducing impedance fluctuations, and increasing the channel bandwidth.

In this way, the second anti-pad 211 can better optimize the impedances of the first sub-pad 1111 and the second sub-pad 1112, and the first anti-pad 221 can further optimize the impedances of the first stub 1121 and the second stub 1122, thereby improving signal transmission quality.

In an exemplary embodiment, referring again to Fig. 7, both the first end of the vertical projection of the first stub 1121 and the first end of the vertical projection of the second stub 1122 are aligned with the first side edge of the coverage area of the first anti-pad 221; neither the second end of the vertical projection of the first stub 1121 nor the second end of the vertical projection of the second stub 1122 exceeds the second side edge of the coverage area of the first anti-pad 221; the first end of the vertical projection of the first stub 1121 is the end of the vertical projection of the first stub 1121 close to the through hole 300; the second end of the vertical projection of the first stub 1121 is the end opposite to the first end of the vertical projection of the first stub 1121; the first end of the vertical projection of the second stub 1122 is the end of the vertical projection of the second stub 1122 close to the through hole 300; the second end of the vertical projection of the second stub 1122 is the end opposite to the first end of the vertical projection of the second stub 1122; the first side edge of the coverage area of the first anti-pad 221 is the side edge of the coverage area of the first anti-pad 221 close to the through hole 300; and the second side edge of the coverage area of the first anti-pad 221 is the side edge opposite to the first side edge of the coverage area of the first anti-pad 221.

It should be noted that, the size and position of the first anti-pad 221 may be determined according to simulation; when both the first end of the vertical projection of the first stub 1121 and the first end of the vertical projection of the second stub 1122 are aligned with the first side edge of the coverage area of the first anti-pad 221, and when neither the second end of the vertical projection of the first stub 1121 nor the second end of the vertical projection of the second stub 1122 exceeds the second side edge of the coverage area of the first anti-pad 221, the impedance optimization of the first stub 1121 and the second stub 1122 is obvious.

In an exemplary embodiment, a ratio of a distance by which the second side edge of the coverage area of the first anti-pad 221 exceeds the second end of the vertical projection of the first stub 1121 to a length of the first stub 1121 is less than 1; and a ratio of a distance by which the second side edge of the coverage area of the first anti-pad 221 exceeds the second end of the vertical projection of the second stub 1122 to a length of the second stub 1122 is less than 1.

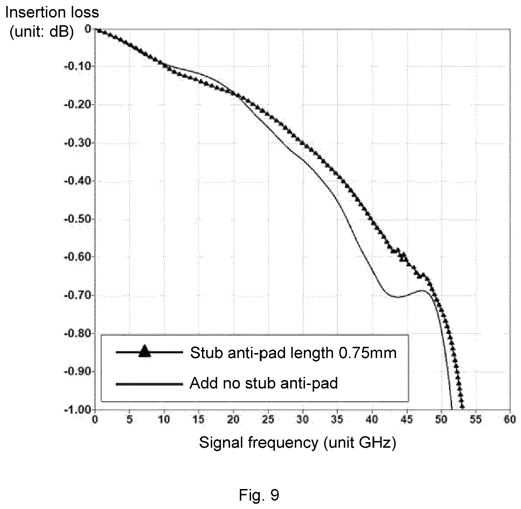

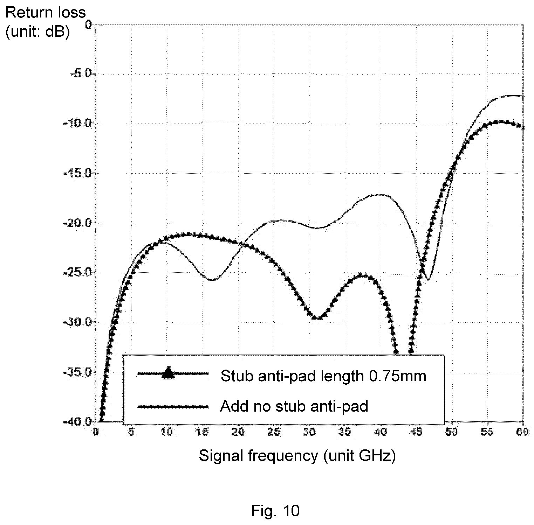

In an exemplary embodiment, by adding a stub anti-pad (i.e. the first anti-pad 221 hereinbefore), the problem of impedance discontinuity at the tail end of the SMD pad can be effectively reduced, the impedance matching and signal integrity performance can be improved, and the channel return loss and insertion loss can be optimized. Specifically referring to Figs. 8 to 10, when the length of the stub 112 of the pad 111 is 0.5 mm, the influence of adding no stub anti-pad on the channel impedance and the influence of adding stub anti-pads of different lengths on the channel impedance are shown in Fig. 8, wherein the horizontal coordinate in Fig. 8 represents the measurement time of a Time Domain Reflectometry (TDR), and the vertical coordinate represents a measurement value corresponding to each measurement time (i.e. channel impedance). It can be seen from figure 8 that the impedance continuity when no stub anti-pad is added is lower than the impedance continuity when a stub anti-pad is added; and as the length of the stub anti-pad increases, the channel impedance continuity gradually increases, and when the length of the stub anti-pad is 0.75 mm, the channel impedance continuity is optimal. Meanwhile, when the length of the stub anti-pad is 0.75 mm, the optimization effect of insertion loss and return-wave loss of the high-speed signal is also obvious, as shown in Figs. 9 and 10. The horizontal coordinate in Fig. 9 represents a signal frequency, and the vertical coordinate represents an insertion loss corresponding to each signal frequency; when the signal frequency reaches a certain frequency value, an insertion loss when a stub anti-pad is added is higher than an insertion loss when no stub anti-pad is added. The horizontal coordinate in Fig. 10 represents a signal frequency, and the vertical coordinate represents a return loss corresponding to each signal frequency; when the signal frequency reaches a certain frequency value, a return loss when a stub anti-pad is added is lower than a return loss when no stub anti-pad is added. Compared with the prior art, the present invention achieves an innovative improvement in technical value, and achieves both signal integrity and design reliability from the perspective of the design of anti-pads on the inner layer of the printed circuit board, thereby solving the signal distortion problem caused by the fact that pad stub impedance in the prior art cannot be optimized.

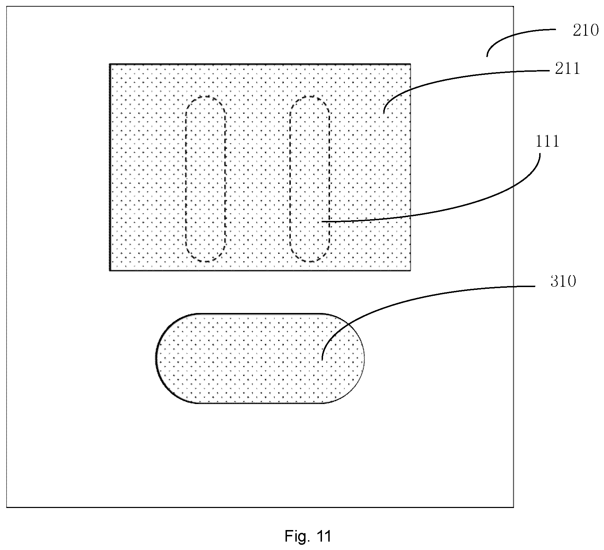

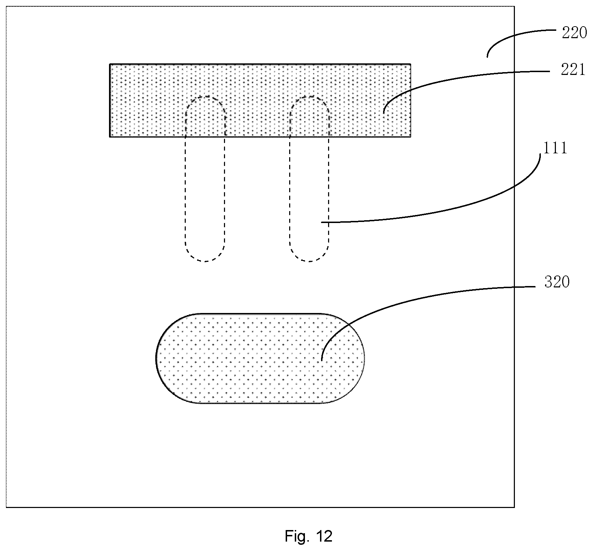

It should be noted that the length of the stub anti-pad is not as long as possible, when the length of the stub anti-pad exceeds twice the length of the stub 112, it will lead to a decrease in impedance continuity. Therefore, when setting the length of the stub anti-pad, the distance by which the stub anti-pad exceeds the stub 112 is usually less than one times the length of the stub 112. As shown in Figs. 11 and 12, after the stub anti-pad has been added, the schematic diagram of the fan-out structure of the first sub-reference layer 210 of the pad 111 is shown in Fig. 11, and the schematic diagram of the fan-out structure of the second sub-reference layer 220 of the pad 111 is shown in Fig. 12.

In an exemplary embodiment, the shape of the coverage area of the first anti-pad 221 is any one of rectangle, ellipse and a racetrack shape.

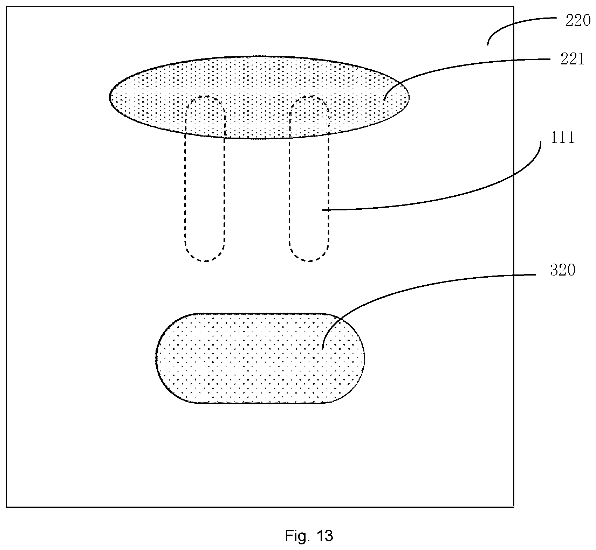

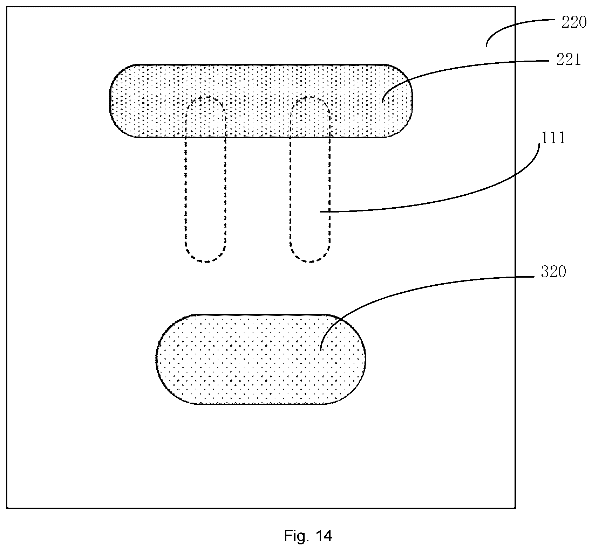

In an exemplary embodiment, in cases when the coverage area of the first anti-pad 221 meets the described size requirement, the shape of the coverage area of the first anti-pad 221 may be any regular shape or irregular shape. In an exemplary embodiment, the shape of a coverage area of the first anti-pad 221 may be rectangle, ellipse, a racetrack shape, or the like. For example, the shape of the coverage area of the first anti-pad 221 may be rectangle, and may also be ellipse or a racetrack shape, as shown in Figs. 13 and 14. That is to say, the same effect can be achieved by replacing the rectangular first anti-pad 221 in Fig. 12 with the oval first anti-pad 221 or the first anti-pad 221 in a racetrack shape.

In an exemplary embodiment, referring again to Figs. 6 and 7, the first sub-reference layer 210 is further provided with a third anti-pad 310, and the second sub-reference layer 220 is further provided with a fourth anti-pad 320; the third anti-pad 310 and the fourth anti-pad 320 are both configured to reduce the impedance of the through hole 300. In this way, the transmission quality of the high-speed signal can be further improved.

In an exemplary embodiment, both the first sub-reference layer 210 and the second sub-reference layer 220 are metal layers connected to the ground terminal.

In this way, not only can the first anti-pad 221 and the second anti-pad 211 be provided on the metal layer connected to the ground terminal, but they can also serve as a reference ground of the pad 111, thereby achieving impedance optimization of the pad and the pad stub 112.

A design method for a printed circuit board having a pad according to the present invention is as follows.
Step 1, simulation optimization is performed:
step 1): a pad size and a lamination layer of a printed circuit board are determined according to the specification of a connector pin and the system design requirement;
step 2): simulation optimization is performed on the printed circuit board, and the channel impedance is optimized by adding a pad anti-pad (i.e. the second anti-pad 211 hereinbefore) and a via-hole anti-pad (i.e. the third anti-pad 310 and the fourth anti-pad 320 hereinbefore), adjusting a fan-out line, etc.;
step 3): a pad stub anti-pad (i.e. the first anti-pad 221 hereinbefore) is added, precisely the impedance at the tail end of the pad is optimized, and the size is determined according to a simulation result.
Step 2: gerber data is made:
   step 1): a circuit schematic diagram is prepared, and components such as a connector are added for arrangement and wiring;
   step 2): PCB design is performed on an output circuit netlist, and a wire outlet manner and an anti-pad, etc. are designed according to a simulation optimization result;
   step 3) a gerber file is output, and it is configured same for the manufacture of a printed circuit board.

In this way, when the widths of the pad anti-pad and the via anti-pad cannot be further improved, the entire impedance fluctuation of the channel can be reduced by using the pad stub anti-pad, and this not only eliminates the need to change the pad size or perform pad trimming, but also optimizes the impedance fluctuation of the SMD while ensuring reliable welding, and can also reduce the reflection of high-speed signals and improve signal integrity.

In addition, the present invention further provides a communication device comprising the printed circuit board according to any one of the above embodiments. The communication device may be a printed circuit board including a surface-mounted device pad or a gold finger pad, and is suitable for a wired communication device and a wireless communication device of 112 Gbps or more.

The present invention provides a printed circuit board having a pad and a communication device, so as to solve the problem, in some cases, of poor transmission quality of a high-speed signal due to the fact that the stub at the tail end of the surface-mounted device pad or the gold finger pad is coupled to the reference ground to form a capacitive impedance discontinuity.

In the present invention, the printed circuit board includes a signal layer and a reference layer. The signal layer is provided with a pad, and the pad comprises a stub; the reference layer is provided with a first anti-pad, the vertical projection of the stub in the reference layer is located in a coverage area of the first anti-pad, and the first anti-pad is used for reducing the impedance of the stub. In this way, a first anti-pad may be provided below a stub area of a pad, and capacitive coupling between the stub and the reference ground is reduced using the first anti-pad, thereby improving the transmission quality of the high-speed signal.

It should be noted that in this description, relational terms such as first and second are only used to distinguish one entity or operation from another entity or operation, and do not require or imply any actual relationship or sequence between these entities or operations. Furthermore, terms such as "comprising", "including" or any other variants are intended to cover the non-exclusive including, thereby making that the process, method, merchandise, or device comprising a series of elements comprise not only those elements but also other elements that are not listed explicitly or the inherent elements to the process, method, merchandise, or device. Without further limitation, an element defined by a sentence "comprising a ..." does not exclude other same elements existing in a process, a method, a commodity, or a device that comprises the element.

The foregoing descriptions are merely specific implementations of the present invention, so that those skilled in the art can understand or implement the present invention. Various modifications to these embodiments will be readily apparent to those skilled in the art. The general principles defined herein may be implemented in other embodiments, without departing from the spirit or scope of the present invention. Therefore, the present invention will not be limited to the embodiments described herein, but should be in accordance with the broadest scope consistent with the principle and novel features disclosed herein.

## Claims

1. A printed circuit board having a pad, comprising: a signal layer and a reference layer;
wherein the signal layer is provided with a pad, and the pad comprises a stub;
the reference layer is provided with a first anti-pad, the vertical projection of the stub in the reference layer is located in a coverage area of the first anti-pad, and the first anti-pad is configured to reduce the impedance of the stub.

2. The printed circuit board according to claim 1, wherein the signal layer comprises a first sub-signal layer and a second sub-signal layer, and the reference layer comprises a first sub-reference layer and a second sub-reference layer; the first sub-signal layer, the first sub-reference layer, the second sub-reference layer and the second sub-signal layer are sequentially stacked; and the first sub-signal layer, the first sub-reference layer, the second sub-reference layer and the second sub-signal layer are provided with through holes penetrating each other;
wherein the first sub-signal layer is provided with the pad and a first signal wiring, and the pad is connected to the first signal wiring;
the second sub-signal layer is provided with a second signal wiring, the first signal wiring is connected to the second signal wiring by means of the through hole, and the second signal wiring is configured to fan out signal;
the first sub-reference layer is provided with a second anti-pad, the second sub-reference layer is provided with the first anti-pad, the second anti-pad is configured to reduce the impedance of the pad, and the vertical projection of the second anti-pad on the second sub-reference layer comprises a coverage area of the first anti-pad.

3. The printed circuit board according to claim 2, wherein the pad comprises a first sub-pad and a second sub-pad, the first signal wiring comprises a first microstrip line and a second microstrip line, and the second signal wiring comprises a first strip line and a second strip line;
wherein the first sub-pad is connected to the first microstrip line, the first microstrip line is connected to the first strip line by means of the through hole, and the first sub-pad comprises a first stub;
the second sub-pad is connected to the second microstrip line, the second microstrip line is connected to the second strip line by means of the through hole, and the second sub-pad comprises a second stub.

4. The printed circuit board according to claim 3, wherein both the vertical projection of the first sub-pad on the first sub-reference layer and the vertical projection of the second sub-pad on the first sub-reference layer are located within a coverage area of the second anti-pad;
the vertical projection of the first stub on the second sub-reference layer and the vertical projection of the second stub on the second sub-reference layer are both located within a coverage area of the first anti-pad.

5. The printed circuit board according to claim 4, wherein both a first end of the vertical projection of the first stub and a first end of the vertical projection of the second stub are aligned with a first side edge of the coverage area of the first anti-pad; and a second end of the vertical projection of the first stub and a second end of the vertical projection of the second stub do not extend beyond a second side edge of the coverage area of the first anti-pad;
wherein a first end of the vertical projection of the first stub is one end of the vertical projection of the first stub close to the through hole; a second end of the vertical projection of the first stub is the end opposite to the first end of the vertical projection of the first stub; a first end of the vertical projection of the second stub is one end of the vertical projection of the second stub close to the through hole; a second end of the vertical projection of the second stub is the end opposite to the first end of the vertical projection of the second stub; the first side edge of the coverage area of the first anti-pad is the side edge of the coverage area of the first anti-pad close to the through hole; and a second side edge of the coverage area of the first anti-pad is the side edge opposite to the first side edge of the coverage area of the first anti-pad.

6. The printed circuit board according to claim 5, wherein a ratio of a distance by which the second side edge of the coverage area of the first anti-pad exceeds the second end of the vertical projection of the first stub to the length of the first stub is less than 1, and a ratio of a distance by which the second side edge of the coverage area of the first anti-pad exceeds the second end of the vertical projection of the second stub to the length of the second stub is less than 1.

7. The printed circuit board according to claim 6, wherein the shape of the coverage area of the first anti-pad is any one of rectangle, ellipse and a racetrack shape.

8. The printed circuit board according to claim 2, wherein a third anti-pad is further provided on the first sub-reference layer, and a fourth anti-pad is further provided on the second sub-reference layer;
wherein the third anti-pad and the fourth anti-pad are both configured to reduce the impedance of the through hole.

9. The printed circuit board according to claim 8, wherein both the first sub-reference layer and the second sub-reference layer are a metal layer connected to a ground terminal.

10. A communication device, comprising the printed circuit board as claimed in any one of claims 1-9.
